# EUROPEAN PATENT APPLICATION

(11) **EP 1 460 495 A2**
(43) Date of publication of application: **22.09.2004**
(21) Application number: 04006706.8
(22) Date of filing: 19.03.2004
(51) Int. Cl.: G04F 10/00

(54) **Oscillator for measuring the running time of an electronic apparatus**

(30) Priority: 20.03.2003 JP 2003078779; 02.03.2004 JP 2004057587
(71) Applicant: SEIKO EPSON CORPORATION, Shinjuku-ku, Tokyo 163-0811 (JP)
(72) Inventor: Endo, Takashi, Suwa-shi, Nagano-ken 392-8502 (JP); Fujii, Yoichi, Suwa-shi, Nagano-ken 392-8502 (JP)
(74) Representative: Hoffmann, Eckart, Dipl.-Ing.

(57) **Abstract**

An oscillator operated with an external power source or an external save power source (Ves), comprises: a clock signal generation unit for generating and outputting a clock signal; a power-on detection unit (5) for detecting the power-on of the external power source; a power-off detection unit (6) for detecting the power-off of the external power source; a running time count unit (4) for counting the running time from the time a power-on detection signal is input to the time a power-off detection signal is input; storage means (9) for storing an accumulated running time up to the power-on time of the external power source; and a control unit (8) for reading the running time at the time of the power-off detection signal being input, reading the accumulated running time from the storage means (9), adding the running time to the accumulated running time, and storing the addition result as a new accumulated running time in the storage means (9).

## Description

The present invention relates to an oscillator capable of accumulating and storing the running time of an electronic apparatus and to an electronic apparatus using the oscillator.

Recently, various electronic apparatuses such as a personal computer, copier, etc., have widely utilized electronic parts or mechanical parts such as an oscillator, a display including a liquid crystal display (LCD), a memory, a central processing unit (CPU), etc.. In general, these electronic apparatuses have their own expiration dates. When the expiration dates are passed, the electronic apparatuses are discarded without exception. However, there are problems that it is difficult to acquire landfill space and the discarded apparatuses have a harmful influence on the earth's environment. For this reason, it is necessary to determine whether or not the used parts are to be recycled and to sort the used parts in accordance with characteristics of the electronic apparatuses or the used parts. Therefore, relatively inexpensive parts are discarded and expensive products such as CPUs are recycled.

In addition, since even electronic apparatuses of the same type have different running times depending on their usage frequencies, the daily actual running time of the electronic apparatuses becomes one item to be managed. In some cases, an electronic apparatus is powered on/off in accordance with the working time in one day. In other cases, the electronic apparatus may be constantly driven without being powered off. Therefore, the running times of these cases are different depending on their usage. In particular, in the electronic apparatus powered on/off in accordance with the working time in one day, it is necessary to accurately count the running time and determine whether or not it is to be recycled based on its accumulated running time.

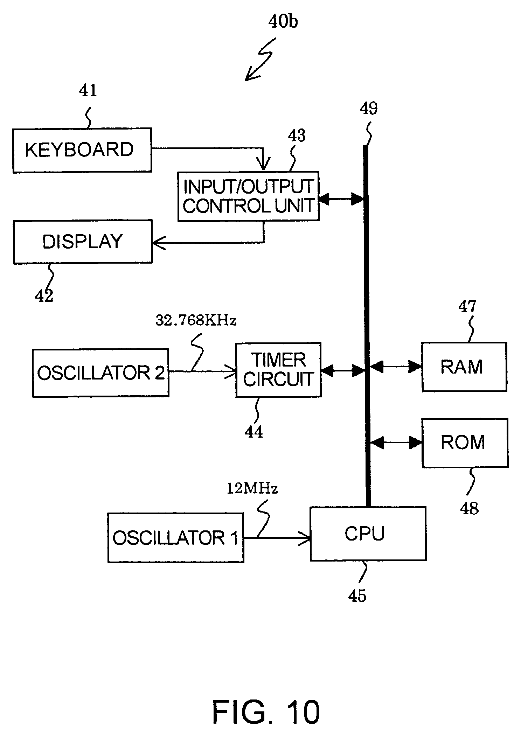

In an electronic apparatus whose accumulated running time must be managed, a construction shown in Fig. 10 is generally employed in order to count the running time. In Fig. 10, the electronic apparatus comprises a CPU 45, oscillators 1, 2, a timer circuit 44, memory devices such as a RAM 47, and a ROM 48, a backup power source (not shown), etc. The running time is accumulated in the timer circuit 44 based on a reference clock signal having a frequency of 32 kHz output from the oscillator 2, and the result is written in the RAM 47 through the CPU bus 49. For example, it is considered that the running time of a liquid crystal display used as a display 42 of a personal computer is accumulated and accurately managed.

In addition, as a representative personal apparatus, there is a cellular phone or a potable notebook personal computer. In these apparatuses, during their unused periods, their requisite functions such as a counting operation is always performed by means of a backup power source. In addition, while its user is moving, the portable electronic apparatus can be used but its battery needs to be periodically charged. Since it is not easy for a user to accurately check the usage times or running time, there is a need for the user to accurately check the actual status of the running time of these apparatuses.

As a conventional example, an arrangement where counter means with a backup battery is provided to count the running time of peripheral devices is disclosed in JP 5-79649 U (see Section 0011 and Fig. 1). As another conventional example, an arrangement where a current detector and a time measurement device are accommodated in one case is disclosed in JP 6-25960 U (see Section 0008 and Fig. 2).

A conventional oscillator or an electronic apparatus using the oscillator having the aforementioned construction has the following problems.

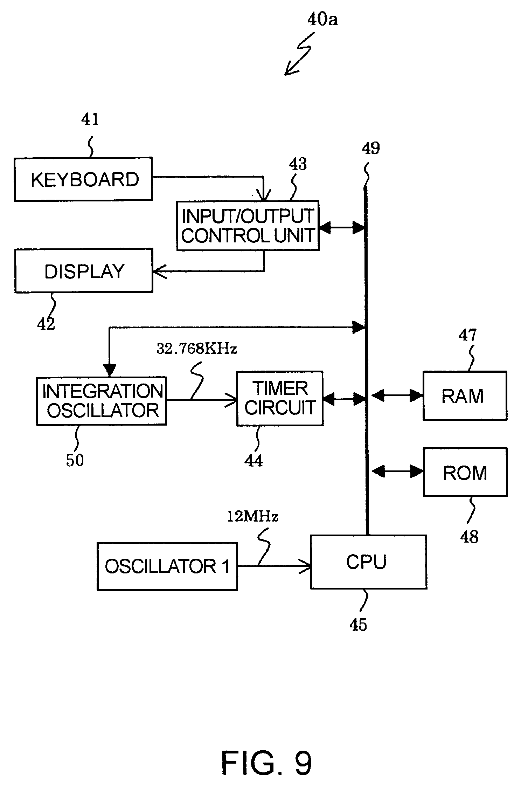

Since the conventional oscillator does not have a function of counting and retaining the running time of the electronic apparatus at power-off time, individual function blocks for retaining and recording the running time shown in Fig. 9 need to be provided in the individual apparatus to store the running time count data in a memory. However, even though all the needed running time count data is stored in a memory, there is a problem in that the currently counted running time count data is lost at power-off time and cannot be stored.

In addition, in order to prevent the loss of data, it is necessary to prepare a dedicated circuit for retaining data in combination with an external storage device such as a hard disk drive and an external backup power source, etc. In addition, since the individual function is not integrated but separately provided in each apparatus, there is a problem in that the size tends to be large in mounting and the cost tends to increase.

In addition, in a cellular phone or a portable notebook personal computer, since there is no function of counting the running time, accumulating running status, and displaying running status, there is a problem in that it is impossible for a user to check the running status of the apparatus.

An object of the present invention is to provide an oscillator capable of counting the running time, storing the count result, and preventing running time count data from being erased at power-off time. Another object of the present invention is to provides a compact low cost oscillator for counting the running time, storing the count result, and preventing running time count data from being erased at power-off time. Still another object of the present invention is to provide an electronic apparatus that uses this oscillator.

These objects are achieved with an oscillator as claimed in claims 1 and 2 and an electronic apparatus as claimed in claim 9. Preferred embodiments of the invention are subject-matter of the dependent claims.

In according with the invention, the operation of the oscillator is powered by a power source voltage supplied by an external save power source at power-off time of an external main power source.

Therefore, the accumulated running time of an electronic apparatus or electronic parts is not erased. In addition, since the save power source is a temporary power source, it is possible to effectively facilitate low power consumption. In addition, in a case where the time period for counting the running time is within the working time of one day, it is not necessary to perform the count operation up to a day, a month, or a year. Therefore, the divider circuit of the running time count unit can be implemented with such a simple construction that the circuit can be obtained in an advantageous size thereof.

The embodiment according to claim 3 has the advantage that the oscillator using the first oscillation circuit can be used for a case where high accuracy of the running time is required, whereas the oscillator using the second oscillation circuit can be used for a case where high accuracy of the running time is not required. In other words, one of the oscillators can be selectively used in accordance with user's selection.

According to a preferred embodiment, after the oscillator was built into an electronic apparatus, the rewrite operation on the accumulated running time can be disabled, so that it is possible to obtain a highly reliable accumulated running time.

According to another embodiment, since the power-on/off number can be counted, the usage frequency can be checked in addition to the running time of the electronic apparatus.

In the embodiment according to claim 10, in an electronic apparatus having a low power consumption mode such as a power down mode, an oscillator capable of retaining the currently accumulated running time by means of a temporary save power source at power-off time of a main power source is used. As a result, since a backup power source for saving the accumulated running time is not needed, a low power consumption electronic apparatus can be obtained.

Hereinbelow, preferred embodiments of the present invention will be described with reference to the drawings, in which:
- Fig. 1: is a block diagram illustrating the construction of an oscillator according to a first embodiment;
- Fig. 2: is a circuit diagram illustrating the construction of an inverter-type oscillation circuit used for the first embodiment;
- Fig. 3: is a circuit diagram illustrating an example of an RC oscillation circuit used for the first embodiment;
- Fig. 4: is a circuit diagram illustrating an example of an oscillator according to the first embodiment of the present invention to which an external power source and a save power source are connected;
- Fig. 5: is a schematic illustration of the construction of a write device used to test the oscillator of the first embodiment;
- Fig. 6: is a flowchart for explaining operations of an example of the first embodiment;
- Fig. 7: is a flowchart for explaining operations of another example of the first embodiment;
- Fig. 8: is a block diagram illustrating the construction of an oscillator according to a second embodiment;
- Fig. 9: is a block diagram illustrating a construction of a personal computer using an oscillator according to the first embodiment in a third embodiment; and
- Fig. 10: is a block diagram illustrating main construction of a personal computer.

### (1) First Embodiment

### (1-1) Construction of First Embodiment

### Construction of Oscillator 1

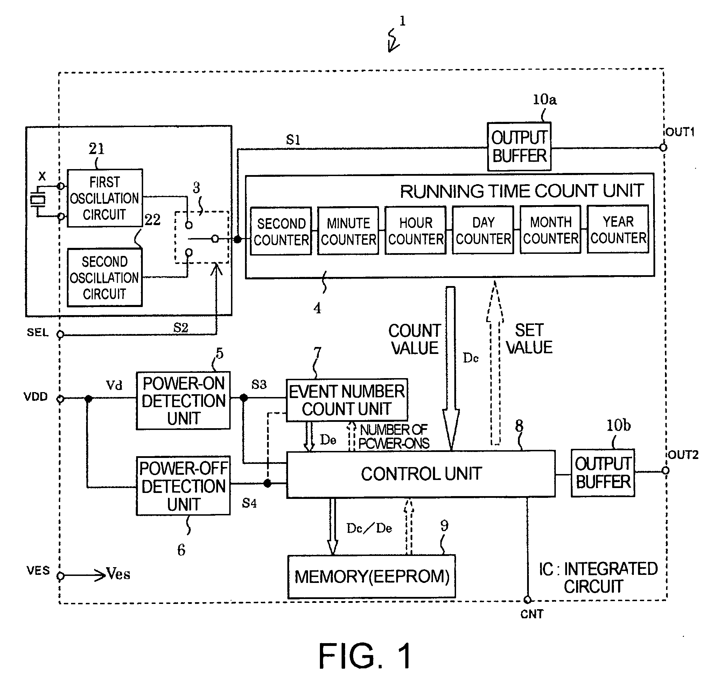

Fig. 1 is a block diagram illustrating the construction of an oscillator according to a first embodiment of the present invention. In Fig. 1, the oscillator 1 comprises a clock signal generation unit 2 having a first oscillation circuit 21, a second oscillation circuit 22, and a selection unit 3 for selecting one of the clock signals from the two oscillation circuits 21 and 22; a running time count unit 4 for counting the running time using the selected clock signal; a power-on detection unit 5 for detecting power-on of an external power source; a power-off detection unit 6 for detecting power-off of the external power source; an event number count unit 7 for counting the number of power-on detections; a control unit 8 for controlling input/output of the running time and number of power-ons of the count unit 4 and the count unit 7, respectively; a memory (storage means) 9 for storing the counted running time and number of power-ons; and an output buffer 10b for outputting count data counted by the count unit 4. In addition, instead of the number of power-ons, the number of power-offs may be counted by the count unit 7 and stored in the memory 9.

The first oscillation circuit 21, which is a circuit oscillating at a predetermined frequency, comprises a piezoelectric resonator such as a tuning-fork-type quartz crystal resonator and an AT-cut-type quartz crystal resonator. In the embodiment, a tuning-fork-type quartz crystal resonator oscillating at a frequency of 32.768 kHz is described as an example. The tuning-fork-type quartz crystal resonator has the advantage that it can be manufactured with a compact structure for the frequency of 32.768 kHz.

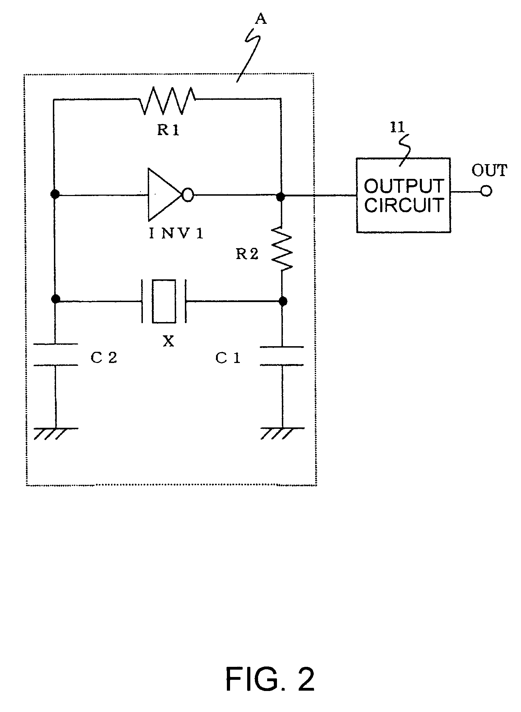

In addition, an inverter-type oscillation circuit may be used as the first oscillation circuit 21. Fig. 2 is a diagram illustrating the construction of such inverter-type oscillation circuit A, of which an output port is connected to an output circuit 11, as one embodiment of the first oscillation circuit 21. The oscillation circuit A comprises a quartz crystal resonator X, a feedback amplifier circuit (inverter INV1, feedback resistor R1) for operating the resonator X, and capacitors C1 and C2 connected to input/output ports of the feedback amplifier circuit. The capacitors C1 and C2, which are the load capacitance for performing a frequency variation fitting operation, etc., in an operating state of the resonator X, are capacitance elements having a fixed capacitance determined by design. The output circuit 11 inputs an oscillation signal from the oscillation circuit A, and performs a wave shaping operation, and outputs a wave-shaped clock signal.

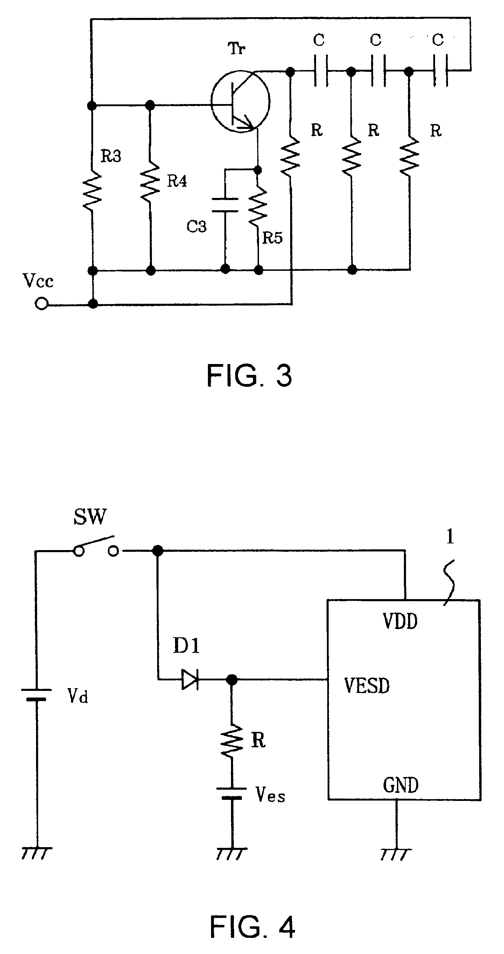

The second oscillation circuit 22 is an RC oscillation circuit oscillating at a low frequency by using a resistor R and a capacitor C. The oscillation circuit has the same oscillation frequency of 32.768 kHz as the first oscillation circuit 21, and it is used for a case where high accuracy is not required. For example, it is useful in a case where time management is performed in units of 12 or 24 hours. Fig. 3 is a circuit diagram of an example of the RC oscillation circuit. The RC oscillation circuit having a three-stage connection of resistors R and capacitors C can perform a 180° phase rotation at an arbitrary frequency and performs oscillation by performing in-phase feedback in accordance with a phase inversion of the amplifier unit. The second oscillation circuit 22 can be constructed with an IC having built-in resistors R and capacitors C, so that the oscillator 1 can be implemented in a small size and with low cost.

The selection unit 3 selects one of the first and second oscillation circuits 21 and 22 based on an external selection signal S2. Alternatively, the clock signal generation unit 2 may be constructed with only one of the two oscillation circuits 21 and 22. The first oscillation circuit is used for a case where high accuracy of running time is required, whereas the second oscillation circuit 22 is used for a case where high accuracy of the running time is not required, and both can be selectively used.

An output signal S1 from the selection unit 3 is output as it is to an output port OUT1 through the output buffer 10a, and it can be used as various clock signals including a reference clock signal of a timer circuit (not shown), for example. The output buffer 10a is a buffer for driving a load circuit (not shown) connected to the output port OUT1.

The count unit 4 is a divider circuit receiving one of the clock signals of the first and second oscillation circuits 21 and 22 for counting the running time from the time of power-on to the time of power-off of an electronic apparatus. The later-described control unit 8 sets the currently accumulated running time to the count unit 4 as an initial value, and the count unit 4 can perform a count operation from the set accumulated running time. Otherwise, with the control unit 8 not setting the initial value, the count unit 4 may perform the count operation from zero.

The power-on detection unit 5 detects power-on of a power source voltage Vd and outputs a power-on detection signal S3 to the count unit 7 or the control unit 8. The power-on detection signal S3 is a trigger signal for setting the last count results to the count unit 4 and the count unit 7 and resuming counting.

The power-off detection unit 6 detects power-off of the power source voltage Vd and outputs a power-off detection signal S4 to the control unit 8. The power-off detection signal S4 is a trigger signal for storing each of the final count results of the count unit 4 and the count unit 7 in the memory 9.

The count unit 7 is a divider circuit receiving the power-on detection signal S3 from the power-on detection unit 5 for counting the number of power-ons. The control unit 8 sets the currently accumulated count result as an initial value, and the count unit 7 can perform a count operation from the set initial value. Otherwise, with the control unit 8 not setting the initial value, the count unit 7 may perform the count operation from zero.

The control unit 8 is a block for controlling input/output of the running time and the number of power-ons in the memory 9. At power-off time (the moment the power supply is switched off), power voltage is supplied by a later-described save power source, and the current count value of the running time as well as the current count value of the number of-power-ons are acquired from the count unit 4 and the count unit 7 as running time count data Dc and number-of-power-ons count data De, respectively, and stored (saved) in the memory 9.

There are two methods of counting the needed accumulated running time. One is a method of starting the count operation after setting the currently accumulated running time stored in the memory 9 to the count unit 4, reading a count result at power-off time, and storing the count result in the memory 9. The other is a method of starting the count operation at zero, reading the running time counted up to power-off time, adding the read running time to the previously accumulated running time stored in the memory 9, and storing the sum as a new accumulated running time in the memory 9. In the latter case where the count unit 4 performs the count operation from zero, the control unit 8 has a function of adding the counted running time and the previously accumulated running time.

Each of these two methods can also be applied mutatis mutandis for counting the number of power-ons.

In addition, the count data Dc and the count data De stored in the memory 9 may be erased based on an external control signal if desired.

As explained, the memory 9 is a memory for storing the count data Dc, the count data De, and other types of data associated with control. A writable or rewritable memory such as a PROM (Programmable Read Only Memory) and an EPROM (Erasable PROM) is used for the memory. The preferred one is an electrically erasable EEPROM (Electrical Erasable PROM) that is not erased at power-off state. The EEPROM may be a flash type EEPROM capable of performing a rewrite operation in units of 1 byte, and rewriting all bits at one time.

The output buffer 10b is a buffer for driving a load circuit (not shown) connected to an output port OUT2.

### Save Power Source

Fig. 4 is a circuit diagram illustrating an example of an oscillator 1 of the present invention to which an external power source and a save power source are connected.

In Fig. 4, when an external power source Vd is turned off by a switch SW, power is supplied from a save power source Ves through a save power supply port VESD of the oscillator 1. Measurement data of the first oscillation circuit 21, the second oscillation circuit 22, the count unit 4, and the count unit 7 in the oscillator 1 supplied with the save power source voltage Ves are then saved to the memory 9, so that the loss of the current values of the count data Dc and that of the count data De can be prevented. The save power source is a power source that is only temporarily used in order to save the count data Dc and the count data De to the memory 9 unlike a backup power source. Therefore, since power is not continuously supplied from the save power source during period the external power source Vd is turned off, it is possible to effectively facilitate low power consumption.

Examples of the save power source Ves include a super capacitor or a secondary battery. In addition, means of charging a capacitor (not shown) with an external power source in advance and performing backup temporarily by using the charged capacitor at power-off time of the power source voltage of the external power source may be employed.

### External Test device

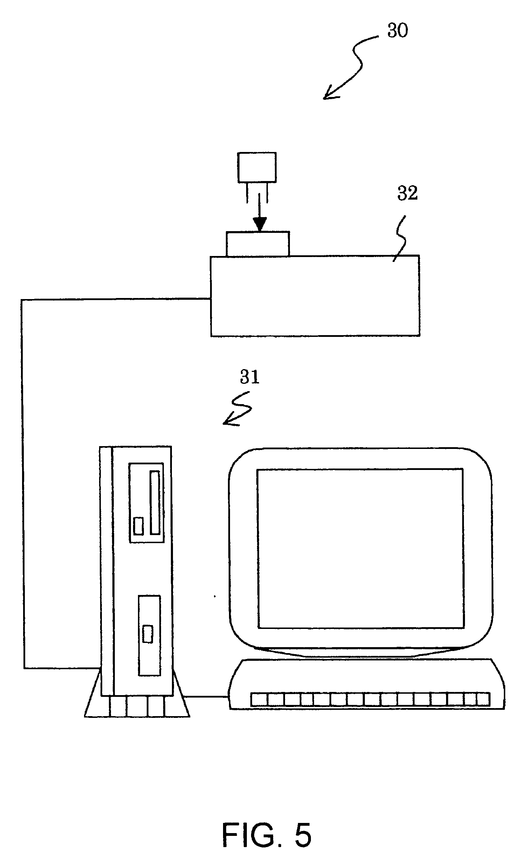

Next, an external test device 30 will be described with reference to Fig. 5.

Fig. 5 is a diagram schematically illustrating the construction of an external test device 30. The external test device 30 comprises a personal computer 31 (hereinafter, referred to as a PC) in which a predetermined application program is installed, and a connection unit 32 for electrical connection with the oscillator 1. Under the control of the PC 31, the connection unit 32 drives the oscillator 1 and commands the control unit 8 in the oscillator 1 to read or write the count data Dc and the count data De stored in the memory 9. The operator of the PC 31 performs an operation necessary for testing with the PC 31, inputs a control signal according to a control command for the oscillator 1 to a control port CNT, and performs a necessary test on the oscillator 1. For example, a test for temporarily operating the count unit 4 or the count unit 7 and determining whether or not their count results are correctly written in the memory 9 is conducted. In addition, a test for setting an count data Dc (externally written into the memory 9) to the count unit 4 and reading and checking the accumulated running time (written into the memory 9 at power-off time of the external power source after a certain time period has passed) may be performed.

The control command is any of multiple commands provided according to a test levels and the actual operation, respectively. The control command is used for a case where the oscillator manufacturer performs an individual test on the oscillator or a case where a user tests a board of an electronic apparatus with the oscillator built-in. For example, the test for outputting the counted time from the count unit 4 of the oscillator 1 to the output port OUT2, and determining whether or not the operation of the count unit 4 is correct is conducted. In this case, the test is performed by inputting the control signal (corresponding to a command associated with the test) to the control port CNT.

### (1-2) Operation of First Embodiment

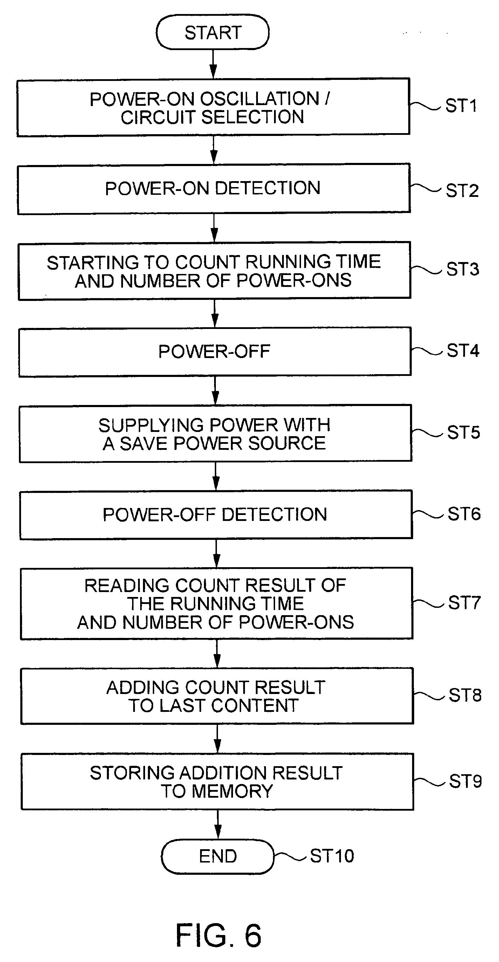

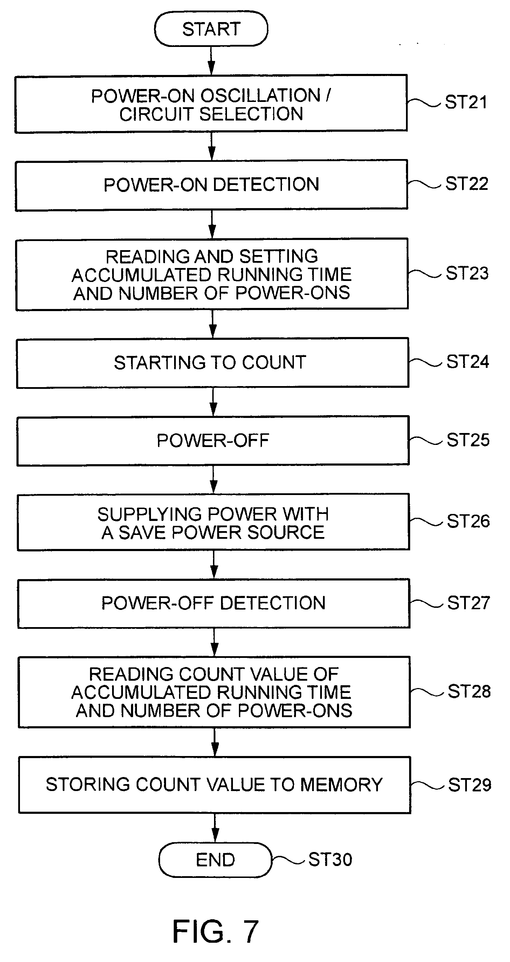

Next, the operation of the first embodiment will be described with reference to Figs. 6 and 7.

### Embodiment 1

Fig. 6 is a flowchart for explaining the operation of the Embodiment 1.

In Embodiment 1, the count operation on the running time and the number of power-ons of an electronic apparatus or an electronic part starts from the initial value of zero at every time power is turned on, and the running time and the number of power-ons at power-off time are added to the accumulated running time and the accumulated number of power-ons stored in the memory 9, respectively. The sums are stored as a new accumulated running time and the accumulated number of power-ons, respectively, in the memory 9.

In addition, Embodiment 1 is described based on an electronic apparatus where the power source is powered-on/off within the working time in one day.

In synchronization with the start of work, the user powers on and drives the electronic apparatus. The first oscillation circuit 21 is selected by the selection unit 3 in accordance with the external selection signal S2 (Step ST1). At power-on time, the power-on detection unit 5 detects power-on and outputs the power-on detection signal S3 to the control unit 8 (Step ST2). The clock signal S1 from the first oscillation circuit 21 is input to the count unit 4 through the selection unit 3, and the power-on detection signal S3 is input to the count unit 7. Next, the count operation with respect to the running time starts and the number of power-ons is incremented, and the running time is counted up to power-off time (Step ST3).

At power-off time, power is supplied from the save power source Ves shown in Fig. 4 through the save power supply port VESD, and the power-off detection unit 6 detects the power-off and outputs the power-off detection signal S4 to the control unit 8 (Step ST4, ST5, ST6). The control unit 8 reads the counted running time as new count data Dc and the number-of-power-ons as new count data De from the count unit 4 and the count unit 7, respectively (Step ST7). Then the control unit 8 reads the old count data Dc and the old count data De stored in the memory 9 as explained above. The new count data Dc and the new count data De are added to the old count data Dc and the old count data De, respectively, and the respective sums are stored (saved) again in the memory 9, and the process ends (Step ST8, ST9, ST10).

Accordingly, up to this step, since the save power source Ves temporarily supplies a power source voltage to the oscillator 1, the count results are not erased but maintained.

In this Embodiment 1, in a case where the time period for counting the running time is within the working time in one day, it is not necessary to perform the count operation up to a day, a month, or a year. Therefore, the divider circuit of the count unit 4 can be implemented with such a simple construction that the circuit can be obtained in an advantageous size thereof.

### Embodiment 2

Next, operations of another example, Embodiment 2, will be described with reference to Fig. 7.

Fig. 7 is a flowchart for explaining the operation of Embodiment 2.

In Embodiment 2, at power-on time of the electronic apparatus, the accumulated running time and the accumulated number of power-ons stored in the memory are set to the count unit 4 and the count unit 7, respectively, and the count operation starts from the respective initial values, and the running time and the number of power-ons accumulated up to power-off time are stored in the memory.

When the user powers on and drives the electronic apparatus, the first oscillation circuit 21 is selected by the selection unit 3 in accordance with the external selection signal S2 (Step ST21). Next, the power-on detection unit 5 detects power-on and outputs the power-on detection signal S3 to the count unit 7 and the control unit 8 (Step ST22). The control unit 8 reads the currently accumulated running time count data Dc and the currently accumulated number-of-power-ons count data De from the memory 9, sets them to the divider circuits of the count unit 4 and the count unit 7, respectively, and the count operation starts (Step ST23, ST24).

At power-off time, power is supplied from the save power source Ves shown in Fig. 4 through the save power supply port VESD, and the power-off detection unit 6 detects the power-off and outputs the power-off detection signal S4 to the control unit 8 (Step ST25, ST26, ST27).

At the time of the power-off detection signal S4 being input, the control unit 8 reads the counted running time as count data Dc and the number-of-power-ons as count data De from the count unit 4 and the count unit 7, respectively (Step ST28). Next, the control unit 8 stores (saves) the thus read count data Dc and count data De in the memory 9, and the process is ended (Step ST29, ST30).

As described above, like Embodiment 1, since the save power source Ves supplies a power source voltage to the oscillator 1, the count results are maintained.

According to this Embodiment, since in the process of reading the accumulated running time and storing it in the memory the process can be performed speedily because no addition operation is required, so that there is an effect on saving operation time.

### (1-3) Effects Obtained with the First Embodiment

As described above, according to the first embodiment of the present invention, the following effects can be obtained.

Since the oscillator comprises an oscillation circuit for generating a clock signal used to count time, a count unit for counting the running time, a count unit for detecting and counting an event such as power-on and/or power-off, and a memory for storing the results, there is an effect to obtain an oscillator capable of counting the accumulated running time of an electronic apparatus or the number of events such as the power-on and the power-off.

In addition, since operations of the oscillation circuit, the running time count unit or the event number count unit, and the control unit are powered by power externally supplied from a save power source at power-off time of an external power source, there is an effect that the counted running time or the number of power-ons is not erased, but is stored in the memory.

In addition, an oscillation circuit comprising resistors and capacitors built in an IC is employed as a secondary oscillation circuit. If it is used at the same frequency as the first oscillation circuit, there is an effect according to its usage that the oscillation circuit can be used in a case where high accuracy is not required for accumulated running time management.

In addition, since a tuning-fork-type quartz crystal resonator having a frequency of 32.768 kHz is used as a piezoelectric resonator, a compact quartz crystal resonator is obtained. Therefore, there is an effect that an oscillator having a small size can be obtained.

In addition, since a single package module comprising two oscillation circuits, that is, the first and second oscillation circuit, and having an accumulated running time counting function according to its use can be implemented, there is an effect that the oscillator can be implemented in a small size and with low cost.

In addition, since an EEPROM is used as a memory for storing the running time or the number of events such as power-on and power-off, there is an effect that count data such as the accumulated running time and the number of power-ons is not erased even at power-off time.

### (2) Second Embodiment

Next, an oscillator according to a second embodiment of the present invention, having write disabling means for running time count data and/or number-of-power-ons count data stored in a memory 9, will be described while focusing on the difference relative to the first embodiment.

Firstly, as for a function of the oscillator, writing of running time count data and number-of-power-ons count data will be described. At the time of manufacturing the oscillator, a test of determining whether or not the oscillator operates normally and counts accurately is performed. Just after the test, running time count data or event number count data counted during the test are stored in the memory 9. Since the oscillator according to this second embodiment counts the running time or the event number of an electronic apparatus, it is necessary to set an accumulated running time or a number of power-ons to zero at the time that the oscillator is built into the electronic apparatus. For this reason, at the time that it is shipped, a write command is input as a write signal from a CNT port, and the running time count data and number-of-power-ons count data stored in a memory 9 are reset to zero.

However, problems may occur in a case where a write operation can be performed after the oscillator has been built into the electronic apparatus. If an accumulated running time counted by the oscillator of the electronic apparatus during a long term use is reset, it might be treated as a short-term used product when it is determined whether the electronic apparatus is suitable for recycling or when the price is determined as a used product for sale. In such cases there is a problem in that the reliability on the accumulated running time is lowered. Therefore, it is preferable that the write function is disabled after the oscillator has been built into the electronic apparatus.

The oscillator according to the embodiment comprises means for disabling the writing signal for the accumulated running time count data and/or the accumulated number-of-power-ons count data to increase reliability of such data.

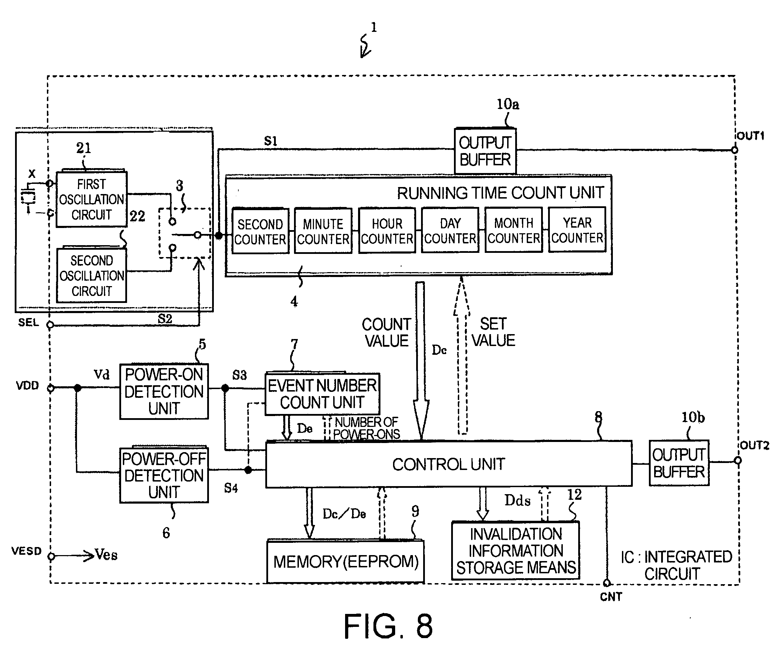

Fig. 8 is a block diagram illustrating the construction of an oscillator according to the second embodiment of the present invention. In the oscillator shown in Fig. 8, a disable data storage means 12 is additionally provided compared to the first embodiment, whereas the remaining structure is the same as that of the first embodiment. Firstly, operations of the storage means 12 will be described. A test of determining whether or not the oscillator 1 of the second embodiment counts the running time and the number-of-power-ons accurately is performed. After the test, an external reset signal is input to the CNT port in order to reset the running time count data and the number-of-power-ons count data to zero. An external write invalidation signal is then input to the CNT port. The control unit 8 outputs disable data Dds to the storage means 12. Next, the disable data Dds transmitted from the control unit 8 is stored in the storage means 12.

The storage means 12 of this embodiment is constructed with a memory where data once written cannot be changed. In the embodiment, an OTPROM (One Time Programmable Read Only Memory) is used. The disable data stored in storage means 12 is 2-bit data of which one bit is allocated to enable/disable an external write signal for overwriting (resetting) the accumulated running time count data Dc and the other bit is allocated to enable/disable a write signal for overwriting (resetting) the number-of-power-offs count data De. When the external write signal is input, the control unit 8 reads the respective bit and performs a write operation if its value is 1 (High) and refrains from a write operation if the bit value is 0 (Low).

### Obtained Effect

As described above, according to the second embodiment of the present invention, it is possible to increase reliability of data on the running time and the number of power-ons used for determining whether or not an electronic apparatus is recycled.

### (3) Third Embodiment

Next, a third embodiment of applying an oscillator of the present invention to a personal computer, as an electronic apparatus will be described.

### Example of Electronic Apparatus

Fig. 9 is a diagram schematically illustrating the construction of a personal computer as an example of an electronic apparatus using an oscillator according to the first embodiment of the present invention.

In the third embodiment, a case where the running time of a main body of the personal computer, that is, the running time for an employee within the working time in one day is accurately recorded is described as an embodiment. In addition, a packaged quartz crystal oscillator (SPXO: Simple Packaged X'stal Oscillator), which is not subjected to temperature control or temperature compensation, is described as an oscillator employed to the third embodiment.

In Fig. 9, one of output ports of the oscillator according to the present invention supplies a clock signal having a frequency of 32.768 kHz to a timer circuit 44 like the conventional art, and the other input/output port is connected to a CPU bus 49 of a CPU 45, whereby communication of needed data such a control command, running time, etc., is performed.

When the personal computer is powered-on by an employee coming to work in the morning, the accumulated running time and number of power-ons of the previous day are set to a counting oscillator 50, and then, a count operation starts. In a case where the employee leaves his/her table for a longer time in order to take a break time or to attend a meeting, the personal computer is powered-off, and the currently accumulated running time and the number of power-ons is stored in a memory. After that, when the employee takes a seat and turns the power on, the running time and the number of power-ons is set as mentioned before and the count operation starts again. These operations are repeated during the working time of the employee. For example, if a function of reading and displaying the accumulated running time is provided to the application program, it is possible for the CPU 45 to read the result in the memory of the oscillator 50 and display the accumulated running time on the display 42.

The behavior of an employee in working time in one day is different day by day. In addition, since behaviors of other employees are naturally different in one day, all the personal computers have different running times.

### Obtained Effect

As described above, in an electronic apparatus using an oscillator according to the present invention, the accumulated running time for each apparatus is semi-permanently stored in the oscillator even though users or methods used in accordance with a schedule of a user in one day are different with the same type of electronic apparatuses. As a result, in a case where an expiration date of a personal computer is reached or exceeded, it is possible to easily determine whether or not it is to be recycled based on the read accumulated running time as a criterion for determination.

In addition, a dedicated circuit for counting the running time and the number of power-ons is used, and an oscillator with a function of a memory for storing the count data being accumulated is used. Accordingly, since additional dedicated circuits for implementing such functions or new external storage devices for preventing the count data from being erased need not be installed, there is an effect that a compact low cost electronic apparatus can be obtained.

In addition, in an electronic apparatus having an operational mode such as a power down mode, an oscillator capable of retaining the currently accumulated running time by means of a temporary save power source is used at power-off time of a main power source. As a result, since a backup power source for saving the counted accumulated running time is not needed, a low power consumption electronic apparatus can be obtained.

### (4) Modified Examples

The present invention, not limited to the aforementioned embodiments, but can be modified in various ways. For example, the following modified embodiments are available.

### First Modified Example

Although a flexural quartz crystal resonator, as an oscillation source is described in the context of the first oscillation circuit of the first embodiment of the present invention, other types of resonator may be used as a quartz crystal resonator, such as an AT-cut-type quartz crystal resonator, a SAW resonator, or a resonator constructed with Piezoelectric Ceramics, Lithium Tantalate, or Lithium Niobate.

### Second Modified Example

Although an inverter-type oscillation circuit using a MOS transistor is described as a first oscillation circuit of the aforementioned first embodiment of the present invention, a Colpitts type oscillation circuit using a bipolar transistor may be used.

### Third Modified Example

Although an RC oscillation circuit using a resistor and a capacitor, as an oscillation source is described in the context of the second oscillation circuit of the first embodiment of the present invention, other types of oscillation circuit may be used. In other words, although, a quartz crystal resonator or a coil cannot be integrated with an IC, the oscillation source can be constructed with an oscillation circuit using a quartz crystal resonator or an LC oscillation circuit using a coil L and a capacitor C.

### Fourth Modified Example

Although a packaged quartz crystal resonator (SPXO), as an oscillator of the third embodiment, is adapted to the present invention, the present invention is not limited to this. For example, a temperature compensated quartz crystal oscillator (TCXO), a voltage controlled quartz crystal oscillator (VCXO) may be used as an oscillator. The running time of an electronic apparatus or an electronic part used for the electronic apparatus can be counted based on output signals of these oscillators. In addition, the present invention can be adapted to an electronic apparatus (such as an cellular phone) having an intermittent receiving mode for intermittently performing a receiving operation or another electronic apparatus (such as an LCD panel in the personal computer) having a power consumption mode (power down mode) for temporarily stop some functions, which can reduce power consumption. In other words, it can be adapted to count the running time of an electronic part or an electronic apparatus in an operational mode for driving or temporarily stopping the apparatus in accordance with a predetermined condition such as the intermittent receiving mode or the power consumption mode.

## Claims

1. An oscillator operated with an external power source (Vd) or an external save power source (Ves), used at power-off time of the external power source (Vd), comprising:
a clock signal generation unit (2) for generating and outputting clock signals having predetermined frequencies;
a power-on detection unit (5) for detecting the power-on of the external power source (Vd) and outputting power-on detection signals;
a power-off detection unit (6) for detecting the power-off of the external power source (Vd) and outputting power-off detection signals;
a running time count unit (4) receiving the clock signals from the clock signal generation unit (2) and counting the running time from the time of a power-on detection signal being input to the time of the next following power-off detection signal being input;
storage means (9) for storing an accumulated running time; and
a control unit (8) for reading the running time at the time of said power-off detection signal being input, reading said accumulated running time from the storage means (9), adding the running time to the accumulated running time, and storing the sum as a new accumulated running time in the storage means (9).

2. An oscillator operated with an external power source (Vd) or an external save power source (Ves), used at power-off time of the external power source (Vd), comprising:
a clock signal generation unit (2) for generating and outputting clock signals having predetermined frequencies;
a power-on detection unit (5) for detecting the power-on of the external power source (Vd) and outputting power-on detection signals;
a power-off detection unit (6) for detecting the power-off of the external power source (Vd) and outputting power-off detection signals;
a running time count unit (4) adapted to be preset to a value representing an accumulated running time, to receive the clock signals from the clock signal generation unit (2), and to further accumulate the running time from the time a power-on detection signal being input to the time the next following power-off detection signal being input;
storage means (9) for storing the accumulated running time; and
a control unit (8) for reading the accumulated running time from the storage means (9) at the time said power-on detection signal being input to preset into the running time count unit (4) a value corresponding to the read accumulated running time, reading the new accumulated running time counted by the running time count unit (4) at the time said power-off detection signal being input, and storing the new accumulated running time in the storage means (9).

3. The oscillator according to Claim 1 or 2, wherein the clock signal generation unit (2) comprises a first oscillation circuit (21) having a piezoelectric resonator (X), oscillating at a predetermined frequency to generate clock signals; and/or a second oscillation circuit (22) having a resistor (R) and a capacitor (C) and oscillating at a predetermined frequency to generate clock signals.

4. The oscillator according to Claim 3, wherein the piezoelectric resonator (X) is a tuning-fork-type quartz crystal resonator.

5. The oscillator according to Claim 3 or 4, wherein the clock signal generation unit (2) further comprises an selection unit (3) receiving the clock signals from the first and second oscillation circuits (22), and selecting one of the clock signals based on external selection signals, and outputting the selected clock signal.

6. The oscillator according to any one of the preceding Claims,
wherein the oscillator further comprises disable data storage means (12) for storing disable data used to disable an operation by which the accumulated running time stored in the storage means (9) is written and changed in accordance with externally input write signals, and
wherein the control unit (8) performs a write operation based on the invalidation information.

7. The oscillator according to any one of the preceding Claims,
wherein the oscillator comprises an event number count unit (7) to which the power-on detection signals or the power-off detection signals are input and which counts the number of power-ons or the number of power-offs, and
wherein the control unit (8) stores the accumulated number of power-ons or the accumulated number of power-offs in the storage means (9).

8. The oscillator according to Claim 7,
wherein the oscillator further comprises disable data storage means (12) for storing disable data used to disable an operation by which the accumulated running time and/or the accumulated event number stored in the storage means (9) is written and changed in accordance with externally input write signals, and
wherein the control unit (8) performs a write operation based on the invalidation information.

9. An electronic apparatus comprising the oscillator according to any one of Claims 1 to 8, wherein the electronic apparatus operates based on output signals of the oscillator.

10. The electronic apparatus according to Claim 9, wherein the electronic apparatus has at least an operational mode for temporarily stopping and driving the oscillator in accordance with a predetermined condition.
